# EUROPEAN PATENT APPLICATION

(11) **EP 0 986 112 A2**
(43) Date of publication of application: **15.03.2000**
(21) Application number: 99113164.0
(22) Date of filing: 07.07.1999
(51) Int. Cl.: H01L 51/20, H01L 27/15, H01L 51/40

(54) **An efficient method for fabricating organic light emitting diodes**

(30) Priority: 11.09.1998 US 151453
(71) Applicant: Hewlett-Packard Company, Palo Alto, California 94304-1185 (US)
(72) Inventor: Sheats, James R., Palo Alto,CA 94301 (US); Roitmann, Daniel B., Menlo Park,CA 94025 (US)
(74) Representative: Liesegang, Eva

(57) **Abstract**

A method of fabricating an organic light emitting diode (OLED) display device (10; 62; 96; 110) utilizes gravure coating techniques to deposit a desired material during at least one step of a fabrication process of forming the OLED display device. Preferably, layers (22; 64, 66 and 68; 82, 83 and 84; 98; 112) of an OLED are formed on a web (41) of transparent flexible substrate (12), so that web processing may be used. A reverse gravure coating technique is preferably utilized to deposit uniform layer (22; 82, 83 and 84; 112) of selected material onto the web. Using the reverse gravure coating technique, a thin layer of organic electroluminescent (EL) material (22), a passivation layer (112) and/or a photoresist layer (84) can be formed on the web. A forward gravure coating technique is utilized to deposit, or "print", a patterned layer of selected material onto the web. Using the forward gravure coating technique, a layer of patterned color EL materials (64; 66 and 68) for color OLED display devices can be formed by printing a number of organic EL materials onto the web. In addition, "bus lines" (98) to augment the conductivity of anodes (14, 16, 18 and 20) in an OLED display device can be formed using the forward gravure coating technique by printing thin lines composed of high conductive material.

## Description

### TECHNICAL FIELD

The invention relates generally to electroluminescent devices and more particularly to a method for fabricating organic light emitting diodes.

### DESCRIPTION OF THE RELATED ART

Organic light emitting diodes (OLEDs) are electroluminescent (EL) devices that generate light energy by exciting an organic EL material as a response to an electric field. OLEDs have electrical and optical characteristics which are attractive for operation within pixel-addressed displays. OLEDs operate at low voltages and are relatively efficient. In addition, OLEDs can be fabricated into thin, lightweight display devices and OLEDs can be designed to emit light of different colors to create color display devices.

Conventional OLEDs include at least one layer of organic electroluminescent (EL) material that is sandwiched between a first layer of transparent conductive material, such as Indium Tin Oxide (ITO), and a second layer of conductive metal having low work function characteristics, such as Ca or Mg. The first layer of transparent conductive material is formed directly onto a transparent dielectric substrate that provides structural integrity to the layer stack. Typically, the substrate is glass, such as silica or borosilicate glass.

The two layers of conductive materials generate an electrical field when both are connected to a voltage source. The first layer of transparent conductive material functions as an anode, while the second layer of conductive metal functions as a cathode. The applied electrical field causes the EL organic material, positioned between the two conducting layers, to emit light. The emitted light then propagates through the first layer of transparent conductive material, and then through the transparent substrate. The emitted light for an array of OLEDs can be utilized to display an image on a display device that includes the OLEDs.

In fabricating OLEDs, the most demanding aspect of the process is the formation of the layer of organic EL material. Ideally, a layer of organic EL material for an OLED must have a thickness of about 1000 angstroms or less. A conventional approach to depositing the organic EL material onto the substrate is to use a spin cast technique. As an example, U.S. Pat. No. 5,247,190 to Friend et al. describes OLEDs having different types of organic EL materials that are coated using the spin cast technique. This technique can provide a flat, uniform layer of organic EL material having a thickness of several microns to a few hundred angstroms. In addition, since spin casting takes place within a controlled environment, the layer of organic EL material can be relatively defect free.

However, there are concerns in utilizing the spin cast technique to form the organic EL layer in OLEDs. A first concern is that the technique is very wasteful and, consequently, an expensive process. Typically, a high percentage of the material is spun from the edges of the substrate and is wasted. A second concern is that the technique is relatively slow. In spin casting, each substrate is relatively small, but must be individually positioned and then spun in order to fabricate the organic EL layer.

In addition to the concerns relating to organic EL layer formation, conventional OLEDs have disadvantages arising from the use of the glass substrate. Conventional OLEDs tend to be very brittle and are prone to breakage due to the inherent physical characteristics of the glass substrate. Furthermore, the rigid glass substrate limits the configuration of OLEDs to flat-surfaced structures.

What is needed is an OLED assembly that overcomes some of the limitations of conventional assemblies. What is further needed is an efficient method of forming one or more organic EL layers for such an OLED assembly.

### SUMMARY OF THE INVENTION

A method for fabricating an organic light emitting diode (OLED) display device utilizes gravure coating techniques to deposit a desired material during at least one step of the fabrication process. Preferably, the various OLED layers are formed on a web of transparent flexible substrate, so that the benefits of web processing may be used.

In a first embodiment, reverse gravure coating technique is utilized to form a layer of organic material, such as the EL material. In the reverse gravure coating technique, the web of flexible substrate is moved with respect to an engraved gravure roll that applies the organic material. The gravure roll is rotated in a direction counter to the direction of movement of the substrate. For example, if the web is moving from right to left, the gravure roll is rotated in a clockwise direction, so that the roll and substrate are moving in opposite directions within a region of roll-to-web contact. To form the layer of organic EL material, a solution of the appropriate organic material is applied to the exterior surface of the gravure roll. The solution of organic material is then transferred onto the substrate by the gravure roll. In the preferred embodiment, the gravure roll has a diameter in the range of 20 to 50 mm. In addition, a doctor blade is utilized to remove excess solution of organic EL material from the gravure roll. The solution is deposited onto the substrate as a wet coating. The web coating is then dried by a lamp, leaving a thin, uniform layer of organic EL material. The process can be repeated to form any additional layers of organic or inorganic material.

In a second embodiment, forward gravure coating technique is utilized to deposit interspersed arrays of discrete organic EL tiles, rather than a uniform layer of organic EL material. This embodiment may be used to fabricate a color OLED display device. The EL tiles are formed on a web of flexible substrate, such that the EL tiles are positioned within pixel regions of the device. The arrays of organic EL tiles are composed of three organic EL materials that have been selected to emit red, green and blue light. The formation of the arrays of EL tiles is a three-stage process in which all of the EL tiles corresponding to a particular color are formed during the same stage.

During each stage, an engraved gravure roll and a doctor blade are employed to form one color-specific array of EL tiles. However, unlike the reverse gravure coating technique, the gravure roll is rotated in the same direction as the web of flexible substrate. Essentially, the gravure roll "prints" the desired EL tiles onto the web. The gravure roll utilized in this embodiment has depressed regions on the exterior surface that correspond to the size of the EL tiles being formed. In addition, the depressed regions are patterned on the surface of the roll that corresponds to the desired positioning of the EL tiles on the web. When the gravure roll is supplied with a solution of organic EL material, the depressed regions retain some of the solution. As the gravure roll is rotated over the web, the solution of organic EL material within the depressed regions is deposit, or "printed," onto the web in a pattern defined by the depressed regions on the roll. The deposited solution is then dried to form the selected type of EL tiles on the web. After the first stage, the process is repeated using gravure rolls with depressed regions that correspond to the size and locations of the other EL tiles.

In a third embodiment, the reverse gravure technique is utilized to form a patterned layer of discrete organic EL tiles of the OLED. Firstly, a uniform layer of organic EL material is deposited on the web of flexible substrate using the reverse gravure coating technique, as described above in reference to the first embodiment. Next, a layer of cathode material is deposited over the layer of organic EL material. In addition, a photoresist layer is formed over the cathode layer by depositing a photoresist material using the same reverse gravure coating technique. In this embodiment, the patterned array of EL tiles is formed by using the photoresist layer as a means for selectively removing portions of the organic EL layer and cathode layer. Conventional photolithographic techniques may be employed. The process may be performed twice, if a color OLED is to be fabricated.

In the fourth and fifth embodiments of the invention, the forward gravure coating technique is utilized to form "bus lines" that augment the signal transfer capability of a layer of transparent conductive material formed between an organic EL layer and the web of flexible substrate of the OLED display device. The layer of transparent conductive material is patterned to form a number of anode strips along a length of the OLED device. In both embodiments, at least one bus line is electrically attached to each anode strip to provide a low resistance path in order to ensure a substantially uniform voltage along the lengths of the anode strips. Preferably, the bus lines are composed of a material having a high electrical conductivity, such as Cu, Ag or Au.

In the fourth embodiment, the bus lines are formed on the web of flexible substrate using the forward gravure coating technique. An engraved gravure roll having depressed regions that correspond to the shape and positioning of the bus lines is utilized to deposit, or "print," a solution of highly conductive material onto the web in thin strips to form the bus lines. The anode strips are formed over the bus lines in a conventional manner, either before or after the bus lines. For example, the transparent conductive material may be sputtered over the bus lines and then etched to form the anode strips. Preferably, the anode strips and bus lines have a side-by-side relationship.

In the fifth embodiment, the bus lines are formed after fabricating the anode strips, the organic EL layer and the cathode layer on the web of flexible substrate. First, a passivation layer is formed over the cathode layer in order to insulate the cathode layer from the bus lines that are to be formed. Next, vias are drilled at various locations through the passivation layer to the layer of anode strips. Since the cathode layer is a patterned layer of cathode strips that are orthogonal to the anode strips, the vias can be drilled at spaces between the cathode strips. After the vias have been drilled, the solution of highly conductive material is deposited onto the passivation layer in thin strips using a gravure roll that is identical to the gravure roll used in the fourth embodiment of the invention. The locations of the thin strips coincide with the vias along each anode strip and, consequently, the vias are filled with the solution of highly conductive material as the bus lines are being formed, creating an electrical connection between the bus lines and the anode strips. Unlike the fourth embodiment, the separation of the bus lines and the anode strips allows the width of the anode strips to be significantly reduced, decreasing the pixel size of the OLED.

An advantage of the invention is that web processing may be used, since the layer stack of the OLED is formed on a flexible substrate. Consequently, the throughput of the fabrication process is significantly improved relative to conventional batch processing of OLED devices. In addition, the method is significantly less wasteful than the spin cast technique for forming layers of an OLED display device.

Another advantage of the invention is that the fabricated OLED display devices can be flexed to shapes that match a variety of contoured surfaces. Furthermore, the use of the flexible substrates yields OLED display devices that are more durable than OLED display devices formed on glass substrates.

### BRIEF DESCRIPTION OF THE DRAWINGS

Fig. 1 is a partial cross-sectional view of an organic light emitting diode (OLED) display device that has been fabricated in accordance with a first embodiment of the present invention.
Fig. 2 is a partial top view of the OLED display device of Fig. 1.
Fig. 3 is cross-sectional view of selected components of a gravure coating system in accordance with the present invention.
Fig. 4 is a partial top view of a color OLED display device that can be fabricated in accordance with a second or third embodiment of the invention.
Fig. 5 is a partial cross-sectional view of the color OLED display device of Fig. 4.
Fig. 6 is an illustration of organic electroluminescent (EL) tiles that are being formed on a web of flexible substrate to fabricate the color OLED display device of Figs. 4 and 5 in accordance with the second embodiment of the invention.
Figs. 7-10 are partial cross-sectional views of an unfinished color OLED display device of Figs. 4 and 5 at various stages of a fabrication process to form the color EL tiles in accordance with the third embodiment of the invention.
Fig. 11 is a partial top view of an OLED display device having augmenting "bus lines" that has been formed in accordance with a fourth embodiment of the invention.
Fig. 12 is a partial cross-sectional view of an unfinished OLED display device of Fig. 11, showing a pair of bus lines and an anode layer formed over the bus lines on a web of flexible substrate.
Fig. 13 is a partial cross-sectional view of a gravure roll utilized to form the bus lines of Figs. 11 and 12.
Fig. 14 is a partial cross-sectional view of an unfinished OLED display device, wherein the augmenting bus lines have been formed after fabricating anode strips on a web of flexible substrate.
Fig. 15 is a partial top view of an OLED display device having augmenting bus lines in accordance with a fifth embodiment of the invention.
Fig. 16 is a partial cross-sectional view of the OLED display device of Fig. 15.
Fig. 17 is a flow chart of an exemplary method of fabricating an OLED display device in accordance with the invention.

### BEST MODE FOR CARRYING OUT THE INVENTION

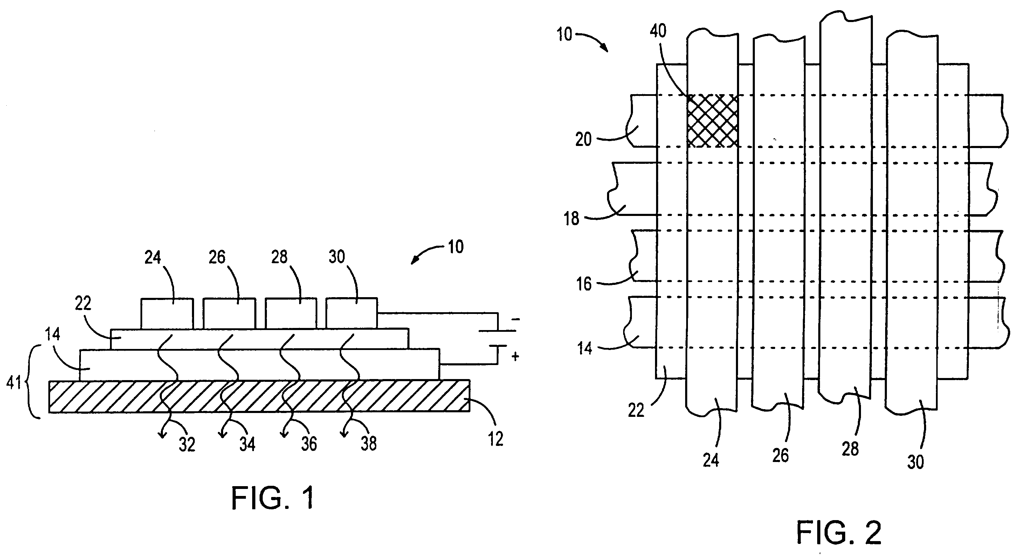

With reference to Figs. 1 and 2, a portion of an organic light emitting diode (OLED) display device 10 that has been fabricated in accordance with a first embodiment of the invention is shown. Fig. 1 is a cross-sectional view of the OLED display device 10, and Fig. 2 is a top view of the same device. The OLED display device 10 includes a transparent substrate 12 (not shown in Fig. 2), a patterned layer of anode strips 14, 16, 18 and 20, an organic electroluminescent (EL) layer 22, and a patterned layer of cathode strips 24, 26, 28 and 30. The OLED display device 10 operates as a display device by emitting light energy 32, 34, 36 and 38 from various pixel regions. A pixel region is an area defined by the overlap of anode and cathode strips. For example, a pixel region 40 is defined by an area within which the anode strip 20 and the cathode strip 24 intersect.

The transparent substrate 12 is preferably comprised of a flexible plastic material, such as Poly(ethylene terephthalate) (PET), so that the OLED display device 10 is more durable than conventional OLED display devices that are made of non-flexible substrates. In addition, the use of a flexible substrate allows the OLED display device 10 to be shaped into a variety of desired forms. For example, if the OLED display device 10 is to be used as a display in a dashboard of an automobile, the OLED display device 10 may be flexed to a shape that matches the contours of the dashboard. Lastly, the use of a flexible substrate allows the organic EL layer 22 to be deposited onto the substrate 12 by utilizing efficient web processing techniques.

The anode strips 14-20 and the cathode strips 24-30 function to generate an electrical field within selected pixel regions. The anode strips 14-20 are composed of a transparent material, such as Indium Tin Oxide (ITO), which permits passage of the emitted light 32-38 from the organic EL layer 22 to the transparent substrate 12. The cathode strips 24-30 may be formed of Ca, Mg, or other comparable material having low work function characteristics. The strips 14-20 and 24-30 may be formed and patterned using conventional methods, such as sputtering and shadow masking techniques, during the fabrication process of the OLED display device 10. An electrical field can be generated in a particular pixel region by creating a potential difference between the anode and cathode strips that intersect at the pixel region. For example, by applying a positive voltage to the anode strip 20 and electrical ground to the cathode strip 24, an electrical field can be created in the pixel region 40 occupied by a portion of the organic EL layer 22.

The organic EL layer 22 is sandwiched between the anode strips 14-20 and the cathode strips 24-30. The organic layer 22 is composed of an organic electroluminescent (EL) material that emits light when excited by an electrical field. A variety of organic EL materials, such as poly(p-phenyenevinylene), that can be utilized in OLED display devices are known in the art. The exact organic material of the organic EL layer 22 is not critical to the invention. However, the thickness of the organic EL layer 22 should be less than 150 nm in order to ensure proper operation of the OLED display device 10. Although only a single organic layer 22 is shown in Figs. 1 and 2, the OLED display device 10 may include one or more additional organic layers, positioned adjacent to the organic EL layer 22.

The organic EL layer 22 is fabricated on an unfinished structure, or an anode-substrate composite 41, of the OLED display device 10. The anode-substrate composite 41 includes the transparent substrate 12 and the layer of anode strips 14-20. The organic EL layer 22 is formed by depositing a uniform layer of organic EL material over the anode-substrate composite 41. As will be explained below, the invention utilizes gravure coating techniques to deposit a wet coating of organic EL material onto the anode-substrate composite 41. The wet coating is then dried by a lamp or other heat source to form the organic EL layer 22.

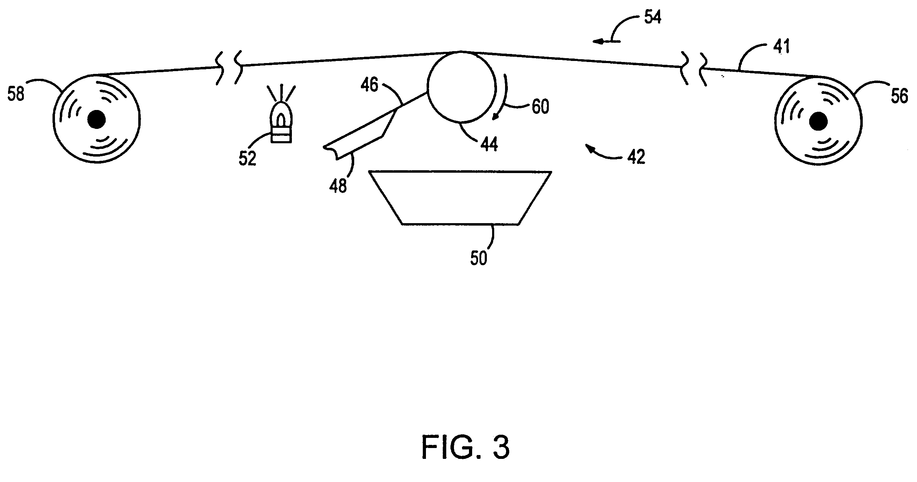

Turning to Fig. 3, selected components of a gravure coating system 42 are shown. The coating system 42 includes an engraved gravure roll 44, a doctor blade 46, a support arm 48, a drip pan 50, and a lamp 52. The gravure coating system 42 is shown in Fig. 3 to be operating on the anode-substrate composite 41 in order to deposit organic EL material onto the composite 41. The anode-substrate composite 41 is a continuous web that is moved in a direction indicated by arrow 54 from a supply roll 56 to a receiving roll 58. The width of the anode-substrate composite 41 may be one to three feet (0.3 to 0.9 meters), but this is not critical.

The gravure roll 44 is essentially a long rod with a circular cross-section. The exterior surface of the gravure roll 44 includes an engraving which provides depressed regions for transferring coating material, as the roll 44 is being rotated. In Fig. 3, only a cross-section of the micro-gravure roll 44 is illustrated. The length of the micro-gravure roll 44 should be equal to or greater than the width of the anode-substrate composite 41. In the preferred embodiment, the gravure roll 44 has a diameter of approximately 20 to 50 mm. In addition, the doctor blade 46 is positioned tangentially adjacent to the gravure roll 44, as shown in Fig. 3. The doctor blade 46 may extend across the entire length of the gravure roll 44. The gravure roll 44 operates in conjunction with the doctor blade 46 to deposit a thin layer of organic EL material, or other coating material, onto the anode-substrate composite 41.

In the preferred embodiment, the gravure coating system 42 utilizes a coating technique that will be referred to as a "reverse gravure" coating technique. In operation, the anode-substrate composite 41 is moved in the direction indicated by the arrow 54. However, the gravure roll 44 is rotated in a direction indicated by arrow 60. As the gravure roll 44 is rotating, a solution of organic EL material is applied to the exterior surface of the gravure roll 44. The solution may be applied to the exterior surface of the gravure roll 44 by partially immersing the gravure roll 44 into a supply of organic EL material. For example, the drip pan 50 may be filled with the solution and raised closer to the gravure roll 44 than shown in Fig. 3, such that a lower portion of the gravure roll 44 is immersed in the solution contained in the drip pan 50. The rotation of the gravure roll 44 coats the entire exterior surface of the roll with the solution, with the doctor blade cooperating to remove excess solution from the roll. Alternatively, the solution of organic EL material may be directed to flow through a passage from a reservoir, not shown, directly onto the region of the gravure roll 44 where the doctor blade 46 contacts the gravure roll 44, as described in U.S. Patent No. 5,266,114 to Iwasaki.

The doctor blade 46 removes any excess organic EL material from the gravure roll 44 in order for the gravure roll 44 to deposit a uniform coating of organic EL material onto the anode-substrate composite 41. The excess organic EL material is captured by the drip pan 50. As portions of anode-substrate composite 41 pass over the gravure roll 44, a thin layer of wet organic EL material is deposited onto the substrate 12. The wet organic EL material is then dried by the lamp 52, as the anode-substrate composite 41 with the layer of wet organic EL material travels adjacent to the lamp 52, forming the organic EL layer 22 of the OLED display device of Figs. 1 and 2. Preferably, the entire coating system 42, along with the anode-substrate composite 41, is situated in a controlled environment so that unwanted particles are not introduced into the layer of organic EL material.

In less preferred embodiments, the gravure coating system 42 utilizes a coating technique that will be referred to as a "forward gravure" coating technique. The forward gravure coating technique employs the same components of the gravure coating system 42 in order to deposit organic EL material onto the anode-substrate composite 41. However, in the forward gravure coating technique, the gravure roll 44 is rotated in the opposite direction indicated by arrow 60. For example, in Fig. 3, the gravure roll 44 would be rotated in the counter-clockwise direction, instead of the clockwise direction used in the reverse gravure coating technique. Using the forward gravure coating technique, the gravure roll 44 essentially "prints" the organic EL material that was on the gravure roll 44 onto the anode-substrate composite 41. Any "printed" patterns caused by the engraving on the exterior surface of the gravure roll 44 are evenly diffused throughout the surface of the substrate 12 to create a thin coating of the organic EL material.

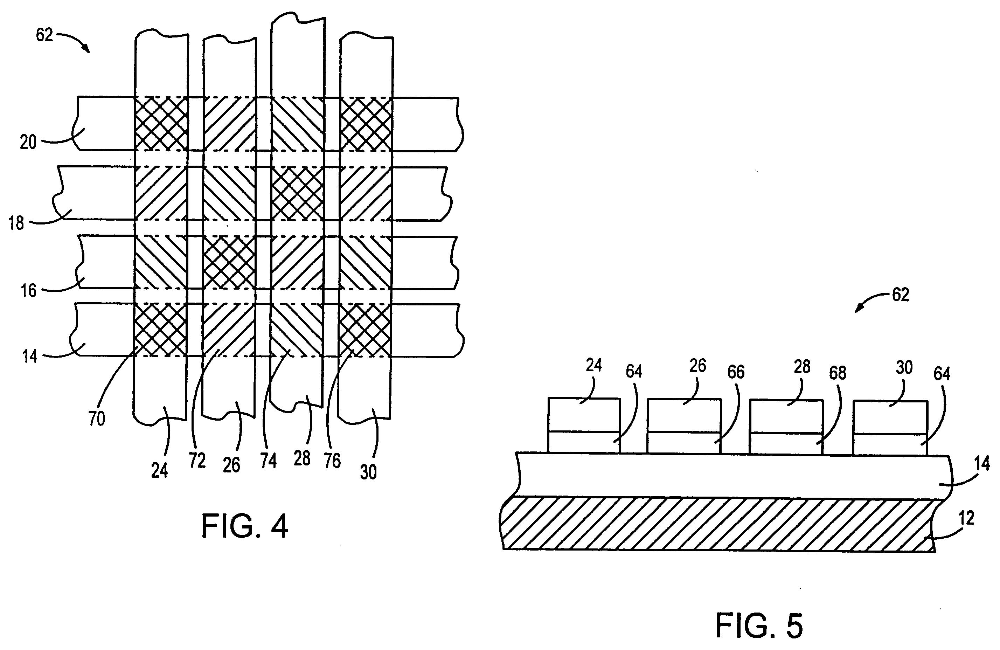

Referring now to Figs. 4 and 5, a color OLED display device 62 is shown. Fig. 4 is a partial top view of the color OLED display device 62, while Fig. 5 is a partial cross-sectional view of the same device. Unlike monochrome OLED display devices, such as the OLED display device of Figs. 1 and 2, the color OLED display device 62 includes a layer of discrete color EL tiles 64, 66 and 68, instead of a uniform organic EL layer. Each of the color EL tiles 64, 66 and 68 is formed of a distinct organic EL material in order to emit light of a particular color. For example, different organic EL materials may be selected for the color EL tiles such that the tiles 64, 66 and 68 emit red, blue, and green light, respectively. Organic EL materials that emit a particular color are well known in the art.

The color-specific EL tiles 64, 66 and 68 are positioned within selected pixel regions throughout the color OLED display device 62. For example, the three left-most color EL tiles 64, 66 and 68 of Fig. 5 are respectively located at pixels 70, 72 and 74 of Fig. 4, while the right-most color EL tile 64 that is aligned with the cathode strip 30 is located within pixel 76. Other non-referenced pixels will also include one of the color-specific EL tiles 64, 66 and 68. A color image can be displayed on the OLED display device 62 by selectively turning "on" combinations of color EL tiles 64, 66 and 68.

In a second embodiment of the invention, the forward gravure coating technique is utilized to form the arrays of organic EL tiles 64, 66 and 65 of the color OLED display device 62. Using the forward gravure coating technique, the organic EL tiles 64, 66 and 68 are formed in a three-stage process. During each stage, all of the organic EL tiles corresponding to a particular color are collectively formed. Three engraved gravure rolls are employed to form the organic EL tiles 64, 66 and 68, one for each type of organic EL tiles. Each gravure roll is positioned along a path of a moving web of flexible substrate to form one of the arrays of organic EL tiles 64, 66 and 68, until all the organic EL tiles are formed.

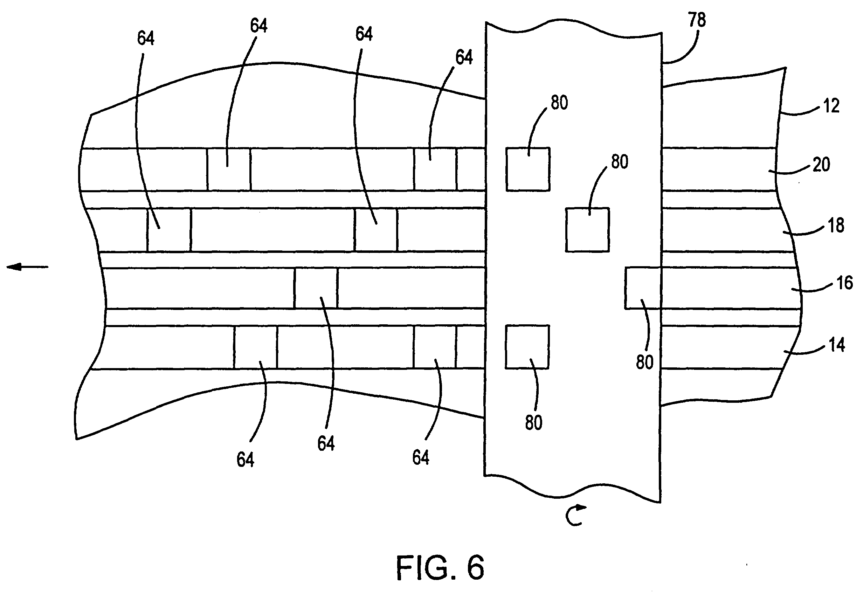

Fig. 6 is an illustration of the formation of the array of organic EL tiles 64 in accordance with the second embodiment. The array is formed during the first stage of the process. The order of the formation of the organic EL tiles 64, 66 and 68 is not critical to the invention. In Fig. 6, a portion of the substrate 12 with the cathode strips 14-20 is shown to be moving relative to an engraved gravure roll 78. Fig. 6 is not drawn to scale. In accordance with the forward gravure coating technique, the gravure roll 78 is rotated in a clockwise direction over the substrate 12. The gravure roll 78 has depressed regions 80 that correspond to the size of the organic EL tiles 64. In addition, the depressed regions 80 are positioned on the exterior surface of the gravure roll 78 to form the organic EL tiles 64 in a selected pattern, as shown by the formed organic EL tiles 64. The organic EL tiles 64 are formed by selectively depositing organic EL material onto the cathode strips 14-20, as the substrate 12 is moved.

Initially, a solution of organic EL material that will form the organic EL tiles 64 is applied to the gravure roll 78, as described above in reference to Fig. 3. The solution of organic EL material fills the depressed regions 80 on the gravure roll 78. Excess solution of organic EL material in the depressed regions 80 and any solution of organic EL material on non-depressed regions of the gravure roll 78 is removed by a doctor blade. As the gravure roll 78 rotates on the moving substrate 12, the solution of organic EL material in the depressed regions 80 is deposited, or "printed" at various locations on the substrate 12, forming the organic EL tiles 64. The deposited solution of organic EL material can then be dried by a lamp. After the organic EL tiles 64 have been formed, the organic EL tiles 66 or 68 may be formed using a second gravure roll in the same manner. The remaining organic EL tiles can be similarly formed using a third gravure roll.

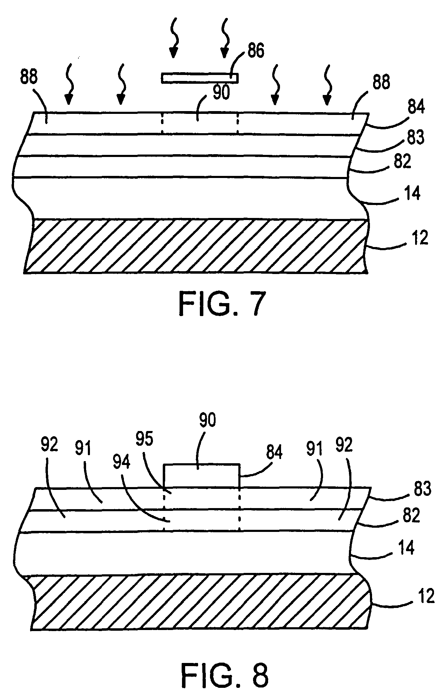

In a third embodiment of the invention, the reverse gravure coating technique is utilized to form the organic EL tiles 64, 66 and 68. Similar to the second embodiment, each array of organic EL tiles is formed during a stage in a three-stage process. A single stage in accordance with the third embodiment will be described with reference to Figs. 7, 8, 9 and 10.

Initially, a patterned layer of anode strips 14-20 is formed on the substrate 12. Following the formation of the anode strips 14-20, a color EL layer 82 is formed on top of the anode strips 14-20, using the reverse gravure coating technique by depositing a color EL material. The selection of the EL material is dependent upon the desired color to be generated by the EL tiles. For example, the EL material of the layer 82 may be an organic EL material that emits red light when subjected to an applied electrical field. A layer of cathode material 83 is then deposited onto the color EL layer 82. Next, a photoresist layer 84 is formed over the color EL layer 82, preferably using the reverse gravure coating technique. The photoresist layer 84 may be formed of a thermally developable photoresist material. The layers 82, 83 and 84 are shown in Fig. 7.

After the color EL layer 82, cathode layer 83 and photoresist layer 84 have been formed, a photolithographic mask 86 is provided over the layer of photoresist material 84 and the mask and layer 88 are exposed to light energy. Only a small segment of the mask 86 is shown in Fig. 7. Exposed portions 88 of the photoresist layer 84 are removed by baking the photoresist layer 84, as shown in Figs. 7 and 8. As an example, the photoresist layer 84 may be baked at 100 degrees Celsius for two minutes to remove the portions 88. However, portion 90 of the photoresist layer 84 that has been protected by the mask 86 is not removed.

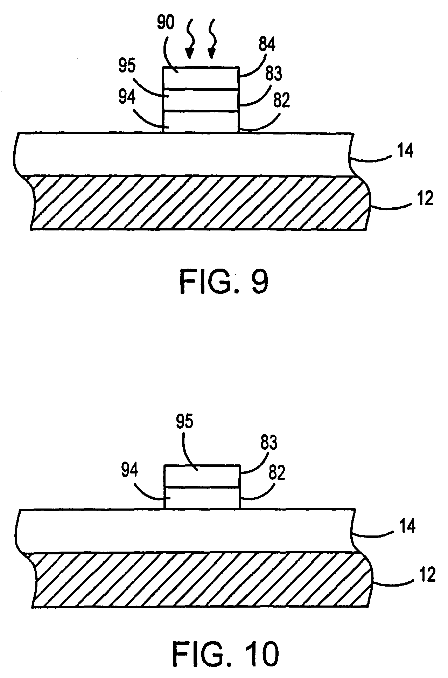

After removing portions 88 of the photoresist layer 84, portions 91 of the cathode layer 83 and portions 92 of the color EL layer 82 are selectively removed in a two step process. First, portions 91 of the cathode layer 83 are etched away. Conventional etching techniques may be utilized to remove portions 91 of the cathode layer 83. Next, portions 92 of the color EL layer 82 are also removed, as shown in Fig. 9. Plasma etching, or other conventional techniques, may be utilized to remove the portions 92 of the color EL layer 82. The remaining portion 90 of the photoresist layer 84 is then removed by a flood exposure of the portion and a second bake. After the portion 90 of the photoresist layer 84 has been removed, only portion 94 of the color EL layer 82 and portion 95 of the cathode layer 83 are left, as shown in Fig. 10. The remaining portion 94 is a color EL tile of the color OLED display device 62. Attached to that color EL tile is a similarly shaped cathode tile, or portion 95 of the cathode layer 83. Although only a single color EL tile with an attached cathode tile is shown in Fig. 10, an entire array of EL tiles of a selected color EL material can be simultaneously formed using this process.

All of the color EL tiles 64, 66 and 68 can be formed in this manner, by repeating the steps with respect to the photoresist layer 84, cathode layer 83 and color EL layer 82. For example, if all the color EL tiles 64 have been formed, the process is repeated twice to form the color EL tiles 66 and 68. During each repeat of the process, another photoresist and cathode layers and a different layer of color EL material are deposited on top of the formed color EL tiles and then selectively removed to form the next type of color EL tiles with the attached cathode tile. In this embodiment, the cathode strips 24-30 of color OLED display device 62 of Fig. 4 are replaced by a number of cathode tiles that are attached to each color EL tiles. These cathode tiles may be electrically connected to form columns of cathode tiles that can function identical to the cathode strips 24-30. Alternatively, the cathode tiles may be individually connected to a driver circuit (not shown) to activate the pixels in the color OLED display device 62.

In certain applications, it is desirable that the dimensions of an OLED display device be relatively large. However, as the dimensions of the OLED display device increase, the luminance from the pixels may vary with distance from an edge of the device, due to the continuous drop in voltage along the anode strips of the device. The drop in voltage is caused by the high sheet resistance of the anode strips. In order to reduce changes in voltage along each of the anode strips, "bus lines^{"} can be electrically connected to the anode strips. Preferably, the bus lines are formed of a highly conductive material, such as Cu, Ag or Au. The bus lines operate to augment the signal transfer capabilities of the anode strips, thereby reducing the voltage drop along the anode strips. The bus lines are formed by printing strips of a metal solution, such as a Cu solution, over the anode strips. The metal solution is composed of particles of the highly-conductive material in a suitable binder. The metal solution strips are then dried or cured to form respective solid, highly-conductive metal bus lines. Such metal solutions are readily available from commercial sources.

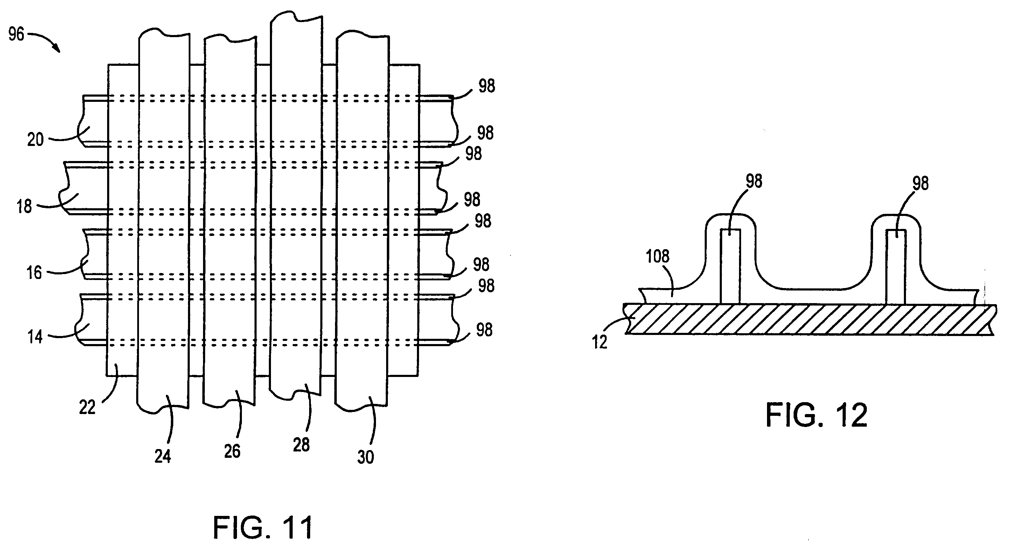

In Fig. 11, an OLED display device 96 having bus lines 98 that have been fabricated in accordance with a fourth embodiment of the invention is shown. When applicable, the same reference numerals of Figs. 1, 2, 4 and 5 will be used. The OLED display device 96 includes the anode strips 14-20. Each anode strip includes two bus lines 98 to augment the conductivity of the anode strips 14-20. The bus lines 98 are formed on the substrate 12, preferably prior to the formation of the anode strips 14-20. The bus lines 98 are formed using the forward gravure coating technique.

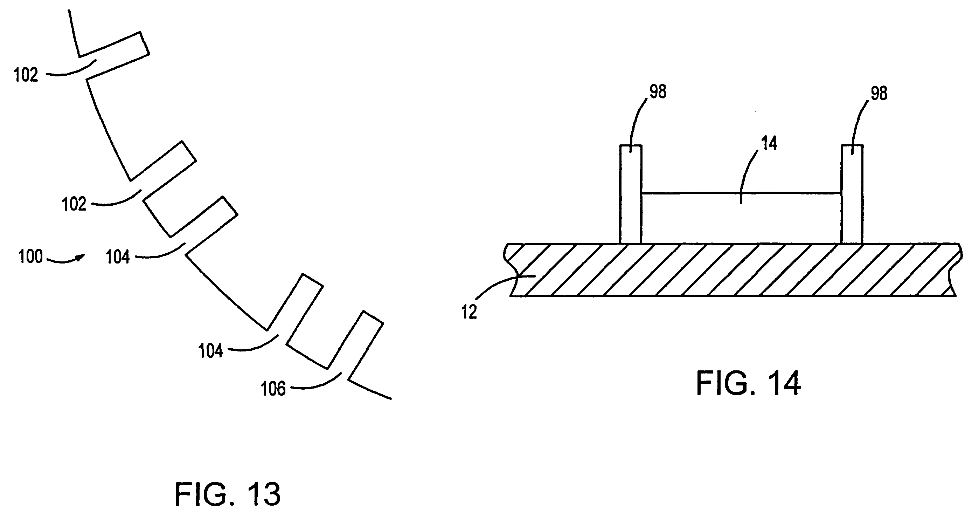

The formation of the bus lines 98 in accordance with the fourth embodiment of the invention will be described with reference to Figs. 12 and 13. Initially, the transparent substrate 12 is provided to form the bus lines 98 directly onto the substrate, as shown in Fig. 12. The bus lines 98 are formed by depositing, or "printing," a solution of Cu in a pattern of thin lines along the substrate 12, using the forward gravure coating technique. The deposition of the solution of Cu is virtually identical to the deposition of the solution of color EL material that was described above in reference to the formation of the color EL tiles of the OLED display device 62 in accordance with the second embodiment of the invention.

In order to "print" the bus lines 98, a gravure roll 100, partially shown in Fig. 13, having engraved patterns with depressed regions 102, 104 and 106 is utilized. The exterior surface of the gravure roll 100 is supplied with the solution of Cu, which fills the depressed regions 102, 104 and 106. A doctor blade can be utilized to remove any excess solution of Cu from the gravure roll 100. The depressed regions 102, 104 and 106 of the gravure roll 100 function to retain the solution of Cu and to transfer the solution of Cu onto the substrate 12, as the gravure roll is rotated over the substrate 12. A pair of depressed regions with the same reference numeral are regions that will form the bus lines 98 attached to the same anode strip. For example, the pair of depressed regions 102 may represent regions that were used to "print" the pair of bus lines 98 attached to the anode strip 20, while the pair of depressed regions 104 may represent regions that were used to "print" the pair of bus lines 98 attached to the anode strip 18. The deposited Cu on the substrate 12 is then dried to form the bus lines 98.

After the bus lines 98 have been formed, a layer of anode material 108 is formed over the bus lines 98, as shown in Fig. 12. The layer of anode material 108 may be formed using a conventional procedure, such as a sputtering process. To form the anode strips 14-20 from the layer of anode material 108, portions of the layer are removed. The removal of the undesired portions of the layer of anode material may be accomplished using conventional photolithographic techniques and plasma etching. After the anode strips 14-20 have been formed, the organic EL layer 22 is formed over the anode strips 14-20 and the bus lines 98. The organic EL layer 22 may be formed using the method that was described as the first embodiment of the invention.

Alternatively, the bus lines 98 may be printed onto the substrate 12, after forming the anode strips 14-20, such that the bus lines 98 are formed next to one of the anode strips 14-20, as shown in Fig. 14. However, a potential problem exists in utilizing this procedure. The thickness of the anode strip 14 is about 1,500 angstroms. In comparison, the thickness of the bus lines 98 is in the order of 1-2 µm. The portions of the bus lines 98 that extend beyond the anode strip 14 may cause irregularities in the organic EL layer 22 that will be formed over the anode strip 14 and the bus lines 98. The irregularities in the organic EL layer may result in a malfunctioning OLED display device.

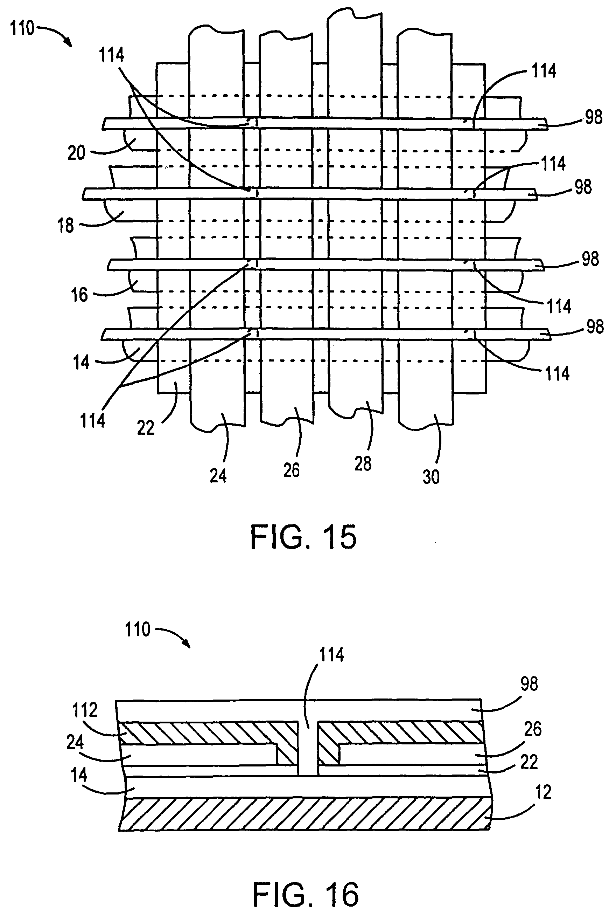

In a fifth embodiment of the invention, the bus lines for augmenting the conductivity of anode strips are formed above the cathode strips of an OLED display device. Turning to Figs. 15 and 16, an OLED display device 110 having bus lines 98 in accordance with the fifth embodiment is shown. Fig. 15 is a partial top view of the OLED display device 110, while Fig. 16 is a partial cross-sectional view of the same device. In this embodiment, the bus lines 98 are separated with their respective anode strips 14-20 by the organic EL layer 22, a layer of cathode strips 24-30, and a passivation layer 112, as shown in Fig. 16. For simplification, the passivation layer 112 is not shown in Fig. 15. The bus lines 98 are electrically connected to their respective anodes strips 14-20 at various locations by vias 114. The number of vias 114 and the spacing between two adjacent vias 114 along a single bus line 98 will depend on the thickness of the bus lines 98. The cathode strips 24-30 are insulated from the bus lines 98 by the passivation layer 112 to prevent short circuits within the OLED display device 110. Although a single bus line 98 is connected to one of the anode strips 14-20 in Fig. 15, additional bus lines may be utilized for each of the anode strips 14-20.

Fabrication of the OLED display device 110 includes forming the anode strips 14-20, the organic EL layer 22, and the cathode strips 24-30. The strips 14-20 and 24-30 may be formed using conventional methods. The organic EL layer 22 may be formed in accordance with the first embodiment of the invention. After forming the cathode strips 24-30, the passivation layer 112 is formed. The passivation layer 112 is preferably formed using the reverse gravure coating technique to deposit a passivation material. Next, the vias 114 are drilled through the passivation layer 112 and the organic EL layer 22. The locations of the vias 114 can be chosen such that the vias 114 are not drilled through the cathode strips 24-30, maintaining the isolation of the bus lines 98 from the cathode strips 24-30. The drilling of the vias 114 may be accomplished by a conventional procedure, such as laser ablation. Lastly, the bus lines 98 are "printed" onto desired locations using the forward gravure coating technique as described above in reference to the fourth embodiment of the invention. The vias 114 are filled with the solution of Cu as the solution is being printed onto the passivation layer 112.

In this embodiment, the width of the bus lines 98 may be wider, with respect to the width of the anode strips 14-20, than the bus lines of the fourth embodiment. In fact, the bus lines 98 of the fifth embodiment may be as wide as the anode strips 14-20. A major advantage of this flexibility is that the pixel size in the fifth embodiment can be made significantly smaller than in the fourth embodiment. In the fourth embodiment, the pixel size is limited by the minimum width of the anode strips, which must be wider than the bus lines. Currently, the minimum width of a bus line using the forward gravure coating technique is about 25 microns. Therefore, the width of the anode strips must be much wider than 25 microns, which increases the minimum pixel size. However, in the fifth embodiment, the width of anode strips 14-20 is not limited by the bus lines 98 since the bus lines are not incorporated into the anode strips. In essence, the width of the anode strips 14-20 in Fig. 15 may be reduced to decrease the size of the pixels in the OLED display device 110. As an example, a pixel size of approximately 25 to 40 microns may be achieved in the fifth embodiment.

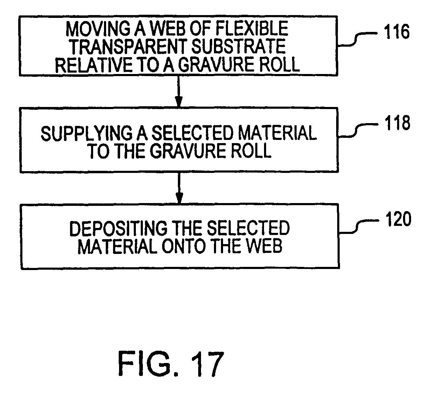

An exemplary method of fabricating an OLED display device will be described with reference to Fig. 17. At step 116, a web of flexible transparent substrate is moved relative to a gravure roll of a gravure coating system. The web of flexible transparent substrate may include one or more layers already formed on the web, depending upon the particular layer being formed. Next, a selected material is supplied to the gravure roll, at step 118. The selected material may be an organic EL material, a passivation material, a solution of Cu or a photoresist material, again depending upon the layer being formed. At step 120, the selected material is deposited onto the web. The selected material may be deposited as a thin, uniform layer, or as a patterned layer defined by the exterior surface of the gravure roll.

## Claims

1. A method of fabricating an electroluminescent (EL) device (10; 62; 96; 110) comprising steps of:
providing a substrate (12); and
forming a layer stack (14, 22, 24, 26, 28 and 30; 14, 24, 26, 28, 30, 64, 66, 68; 14, 82, 83 and 84; 14, 22, 24, 26, 98 and 112) on said substrate, including forming at least one EL layer (22; 64, 66 and 68; 82) and conductive layers (14, 24, 26, 28, 30; 14 and 83) for applying a potential difference across said at least one EL layer,
wherein said step of forming said layer stack includes utilizing gravure coating techniques to deposit at least one layer (22; 64, 66 and 68; 82, 83 and 84; 98; 112) of said layer stack.

2. The method of claim 1 wherein said step of providing said substrate (12) includes moving (116) a web (41) of flexible substrate material relative to a gravure roll (44, 78 and 100) that is supplied with material for depositing said at least one layer (22; 64, 66 and 68; 82, 83 and 84; 98; 112) utilizing said gravure coating techniques.

3. The method of claim 2 further comprising supplying organic EL material to said gravure roll (44, 78 and 100), said step of utilizing said gravure coating techniques being implemented as a reverse gravure operation in which a contact region of said gravure roll with said web (41) is rotating in a direction opposite to said movement of said web.

4. The method of claim 3 wherein said step that includes implementing said reverse gravure operation includes removing excess organic EL material from said gravure roll (44, 78 and 100) by using a doctor blade (46) that is positioned tangentially relative to said gravure roll.

5. The method of claim 2 further comprising a step of using said gravure roll (44, 78 and 100) to print a first pattern of pixel locations (70, 72, 74 and 76) onto said web (41), including depositing EL material (64) onto said pixel locations in said first pattern.

6. The method of claim 5 further comprising a step of printing second and third patterns of pixel locations (70, 72, 74 and 76) onto said web such that first, second and third patterns are associated with generating light energy (32, 34, 36 and 38) of first, second and third colors, respectively, wherein printing said first, second and third patterns includes depositing EL materials (66 and 68) during reverse gravure coating operations, said pixel locations of said first, second and third patterns being individually addressable with respect to activating said EL materials within said pixel locations.

7. The method of claim 2, 3 or 4 wherein said step of utilizing said gravure coating techniques includes supplying a photoresist material to said gravure roll (44, 78 and 100) such that a photoresist layer (84) is deposited above said at least one EL layer (22; 64, 66 and 68), said method further comprising a step of patterning said at least one EL layer using said photoresist layer, thereby defining an array of EL pixels on said substrate (12).

8. The method of claim 1, 2, 3, 4, 5, 6 or 7 wherein said step of forming said layer stack (14, 22, 24, 26, 28 and 30; 14, 24, 26, 28, 30, 64, 66, 68; 14, 82, 83 and 84; 14, 22, 24, 26, 98 and 112) includes forming a patterned anode layer and a patterned cathode layer (24, 26, 28 and 30) on opposite sides of said at least one EL layer (22; 64, 66 and 68; 82), said patterned anode layer having anode segments (14, 16, 18 and 20), said step of utilizing said gravure coating techniques being employed to provide low resistance paths for signals to said anode segments.

9. The method of claim 8 wherein said step of utilizing said gravure coating techniques includes printing low resistance bus lines (98) adjacent to said anode segments (14, 16, 18 and 20), said bus lines having a sheet resistance less than a sheet resistance of said anode segments.

10. The method of claim 8 wherein said step of utilizing said gravure coating techniques includes printing low resistance bus lines (98) on a side of said at least one EL layer (22; 64, 66 and 68) opposite to said anode segments (14, 16, 18 and 20), said low resistance bus lines being connected to said anode segments (14, 16, 18 and 20) by conductive vias (112).
